# EUROPEAN PATENT APPLICATION

(11) **EP 4 800 365 A1**
(43) Date of publication of application: **02.09.2026**
(21) Application number: 26154630.3
(22) Date of filing: 28.01.2026
(51) Int. Cl.: G01L 19/06, H01H 35/34

(54) **WELDING-TYPE SYSTEMS USING FLUID SENSORS WITH BOND RESISTING SUBSTANCES**

(30) Priority: 27.02.2025 US 202563764042 P; 16.01.2026 US 202619451693
(71) Applicant: Illinois Tool Works Inc., Glenview IL 60025 (US)
(72) Inventor: MARCUSEN, David P., Glenview, 60025 (US)
(74) Representative: HGF

(57) **Abstract**

The present disclosure contemplates the use of a bond resisting substance (e.g., conductive grease, dry powder, etc.) applied between a bonding sheet and circuit board of a fluid sensor of a welding-type power supply. In some examples, the bond resisting substance prevents unwanted and/or excessive bonding of the bonding sheet to the circuit board, thereby preventing erroneous fluid detections by the fluid sensor.

## Description

### CROSS REFERENCE TO RELATED APPLICATIONS

This application claims priority to, and the benefit of, U.S. Provisional Patent Application No. 63/764,042, entitled "WELDING-TYPE SYSTEMS USING FLUID SENSORS WITH BOND RESISTING SUBSTANCES," filed February, 27, 2024, the entire contents of which are hereby incorporated by reference.

### TECHNICAL FIELD

The present disclosure generally relates to welding-type systems, and, more particularly, to welding-type systems using fluid sensors with bond resisting substances.

### BACKGROUND

Some welding operations use fluids (e.g., gas) to shield a weld from atmospheric effects that can cause oxidation and/or result in unwanted welding impurities. Performing welding operations without such fluid can result in poor quality welds.

Limitations and disadvantages of conventional and traditional approaches will become apparent to one of skill in the art, through comparison of such systems with the present disclosure as set forth in the remainder of the present application with reference to the drawings.

### BRIEF SUMMARY

The present disclosure is directed to welding-type systems using fluid sensors with bond resisting substances, substantially as illustrated by and/or described in connection with at least one of the figures, and as set forth more completely in the claims.

These and other advantages, aspects and novel features of the present disclosure, as well as details of an illustrated example thereof, will be more fully understood from the following description and drawings.

### BRIEF DESCRIPTION OF THE DRAWINGS

FIG 1. shows an example of a welding-type system, in accordance with aspects of this disclosure.
FIGS. 2a-4 show various views of an example valve and sensor assembly that might be used in the example welding-type system of FIG. 1, in accordance with aspects of this disclosure.
FIGS. 5a-5c show various exploded views of an example fluid sensor that might be used in the example valve and sensor assembly of FIGS. 2a-4, in accordance with aspects of this disclosure.
FIGS. 6a-6b show examples of a contact switch and switch contact surface of the example fluid sensor of FIGS. 5a-5c, in accordance with aspects of this disclosure.
FIG. 7 shows an example of a stencil and roller that might be used to manufacture the example fluid sensor of FIGS. 5a-5c, in accordance with aspects of this disclosure.

The figures are not necessarily to scale. Where appropriate, the same or similar reference numerals are used in the figures to refer to similar or identical elements. For example, reference numerals utilizing lettering (e.g., inner switch contact surface 508a, outer switch contact surface 508b) refer to instances of the same reference numeral that does not have the lettering (e.g., switch contact surfaces 508).

### DETAILED DESCRIPTION

A recurring issue in welding-type systems is the absence of fluid (e.g., gas) flowing through the system. For example, some welding-type systems rely on shielding gas to shield welds against exposure to oxygen that can cause oxidization of the welds, which can give rise to poor quality welds with welding impurities. As another example, some plasma systems rely on gas to create the plasma. If the operator forgets or neglects to connect the system to a fluid tank, forgets/neglects to open the valve of the fluid tank, and/or otherwise forgets/neglects to enable fluid/gas to flow in the system, substantial issues can arise.

This disclosure contemplates using a fluid sensor to detect when fluid is flowing in the welding-type system, so that an operator can be reminded to enable fluid flow if they have not already done so. In some examples, the fluid sensor has a domed contact switch that deforms to electrically connect two switch contact surfaces when sufficient (e.g., a threshold amount of) fluid pressure is present. In some examples, the contact switch undeforms and/or otherwise reverts to a normal and/or resting position, shape, and/or state when sufficient fluid pressure is no longer present, thereby breaking the electrical connection. In some examples, the fluid sensor outputs an electrical signal based on, and/or representative of, whether sufficient fluid pressure is present in the welding-type system (and/or whether there is an electrical connection between switch contact surfaces).

However, in some examples, the contact switch may be prevented from undeforming and/or reverting back to a normal/resting position/shape/state when sufficient fluid pressure is no longer present. For example, an adhesive bond between a bonding sheet (on which the contact switch is integrated/positioned) and a circuit board (on which the switch contact surfaces are positioned/integrated) may generate enough force to overcome the natural elasticity of the contact switch and prevent its reversion to normal when sufficient fluid pressure is no longer present. In some examples, this issue is especially acute if the adhesive bond is too close to the contact switch and/or switch contact surfaces. This disclosure thus contemplates using a bond resisting substance (e.g., a powder and/or grease substance) to resist an adhesive bond proximate the contact switch and/or switch contact surfaces, thereby ensuring proper operation of the contact switch and/or fluid sensor.

Some examples of the present disclosure relate to a fluid sensor, comprising: a fluid chamber having a fluid inlet through which fluid can enter the fluid chamber, the fluid chamber further having a chamber opening; a circuit board positioned adjacent the fluid chamber, the circuit board comprising a switch contact surface positioned in or adjacent the chamber opening of the fluid chamber; a bonding sheet connected to the circuit board via an adhesive bond; a contact switch disposed on the bonding sheet, the contact switch being brought into electrical contact with the switch contact surface of the circuit board by the adhesive bond between the circuit board and the bonding sheet, the contact switch being positioned in or adjacent the chamber opening of the fluid chamber, the contact switch being configured to deform in response to a fluid pressure within the fluid chamber exceeding a pressure threshold; and a bond resisting substance positioned between the circuit board and the bonding sheet proximate the switch contact surface, the bond resisting substance resisting the adhesive bond between the circuit board and the bonding sheet proximate the switch contact surface, thereby stopping the adhesive bond between the circuit board and the bonding sheet from preventing reversion of the contact switch to an undeformed state after the fluid pressure within the fluid chamber no longer exceeds the pressure threshold.

In some examples, the bond resisting substance comprises a powder or a grease. In some examples, the switch contact surface comprises a first switch contact surface, the circuit board further comprising a second switch contact surface that is electrically insulated from the first switch contact surface by an insulating portion of the circuit board. In some examples, the first switch contact surface encircles the second switch contact surface.

In some examples, the contact switch is configured to make electrical contact with the second switch contact surface, and electrically connect the first and second switch contact surfaces, when the contact switch deforms in response to the fluid pressure within the fluid chamber exceeding the pressure threshold. In some examples, the circuit board further comprises circuit board circuitry configured to generate a fluid detection signal when the first and second switch contact surfaces are electrically connected, and generate a fluid non-detection signal when the first and second switch contact surfaces are not electrically connected. In some examples, the contact switch is comprised of an electrically conductive material.

In some examples, the contact switch comprises a plurality of legs extending from a central dome, the plurality of legs being in electrical contact with the switch contact surface of the circuit board. In some examples, the central dome is configured to deform in response to the fluid pressure within the fluid chamber exceeding the pressure threshold. In some examples, the plurality of legs comprises a first leg and a second leg, the bond resisting substance being applied to the switch contact surface between the first leg and the second leg, the bond resisting substance resisting the adhesive bond at the switch contact surface between the first leg and the second leg.

Some examples of the present disclosure relate to a method of manufacturing a fluid sensor, comprising: adhesively bonding a circuit board to a bonding sheet, the circuit board comprising a switch contact surface, and the bonding sheet comprising a contact switch that is brought into electrical contact with the switch contact surface of the circuit board by adhesively bonding the circuit board to the bonding sheet, the contact switch being configured to deform in response to a pressure exerted against the contact switch exceeding a pressure threshold; applying a bond resisting substance between the circuit board and the bonding sheet prior to adhesively bonding the circuit board to the bonding sheet, the bond resisting substance resisting an adhesive bond between the circuit board and the bonding sheet proximate the switch contact surface, thereby stopping the adhesive bond between the circuit board and the bonding sheet from preventing reversion of the contact switch to an undeformed state after the pressure exerted against the contact switch no longer exceeds the pressure threshold; and connecting the circuit board to a fluid chamber such that the contact switch and switch contact surface are positioned in or adjacent a chamber opening of the fluid chamber, the fluid chamber having a fluid inlet through which fluid can enter the fluid chamber and exert the pressure against the contact switch.

In some examples, the bond resisting substance comprises a powder or a grease. In some examples, the switch contact surface comprises a first switch contact surface, the circuit board further comprising a second switch contact surface that is electrically insulated from the first switch contact surface by an insulating portion of the circuit board. In some examples, the first switch contact surface encircles the second switch contact surface.

In some examples, the contact switch is configured to make electrical contact with the second switch contact surface, and electrically connect the first and second switch contact surfaces, when the contact switch deforms in response to the fluid pressure within the fluid chamber exceeding the pressure threshold. In some examples, the circuit board further comprises circuit board circuitry configured to generate a fluid detection signal when the first and second switch contact surfaces are electrically connected, and generate a fluid non-detection signal when the first and second switch contact surfaces are not electrically connected. In some examples, the contact switch is comprised of an electrically conductive material.

In some examples, the contact switch comprises a plurality of legs extending from a central dome, the plurality of legs being in electrical contact with the switch contact surface of the circuit board. In some examples, the central dome is configured to deform in response to the pressure within the fluid chamber exceeding the pressure threshold. In some examples, the plurality of legs comprises a first leg and a second leg, the bond resisting substance being applied to the switch contact surface between the first leg and the second leg, the bond resisting substance resisting the adhesive bond at the switch contact surface between the first leg and the second leg.

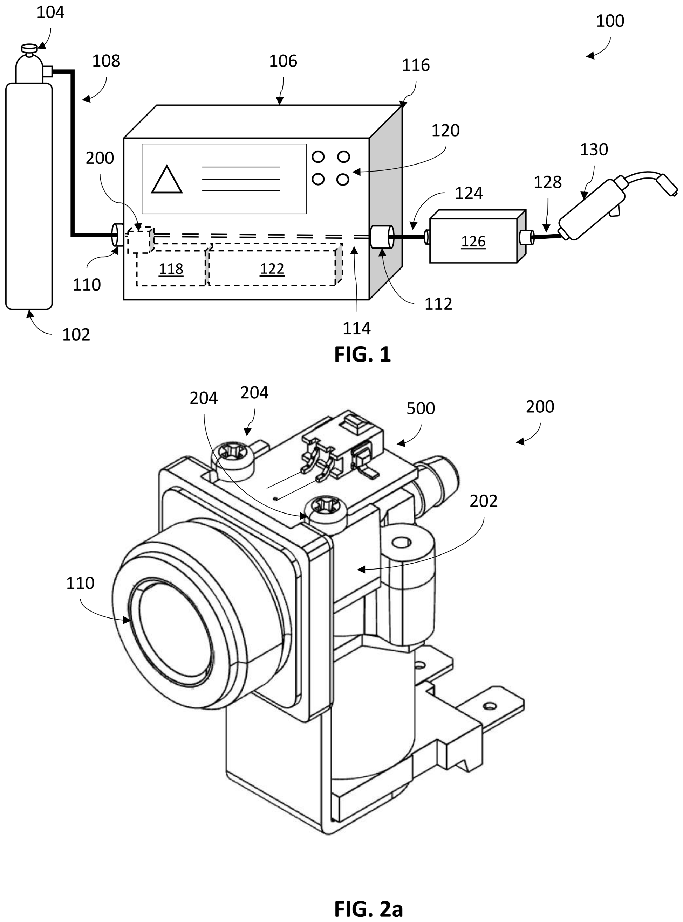

FIG. 1 shows an example of a welding-type system 100. As shown, the welding-type system 100 includes a fluid supply tank 102. In some examples, the fluid supply tank 102 contains fluid (e.g., gas) used in various welding-type operations. In some examples, the fluid is one or more of an oxygen, nitrogen, argon, hydrogen, helium, carbon dioxide, blended, and/or other gas.

In the example of FIG. 1, the fluid tank 102 has a tank valve 104. In some examples, the tank valve 104 can be opened or closed by hand. In some examples, closing the tank valve 104 stops fluid from flowing from the fluid tank 102, and opening the tank valve 104 allows fluid to flow from the fluid tank 102. In some examples, when the tank valve 104 is open, the fluid stored in the fluid tank 102 flows to a welding-type power supply 106 connected to the fluid tank 102.

In the example of FIG. 1, the fluid supply tank 102 is connected to the welding-type power supply 106 via a fluid conduit 108. More particularly, the fluid supply tank 102 is shown connected to a fluid input connector 110 of the welding-type power supply 106 via the fluid conduit 108. In some examples, when the tank valve 104 is open, the fluid stored in the fluid tank 102 flows to the fluid input connector 110 of the welding-type power supply 106 through the fluid conduit 108.

In the example of FIG. 1, the fluid input connector 110 of the welding-type power supply 106 is shown as being in fluid communication with an output connector 112 of the welding-type power supply 106. More particularly, the fluid input connector 110 and output connector 112 are shown as being connected via a fluid line 114. The fluid line 114 connecting the fluid input connector 110 and output connector 112 is shown in dashed lines to indicate that the fluid line 114 is housed within a power supply housing 116 of the welding-type power supply 106.

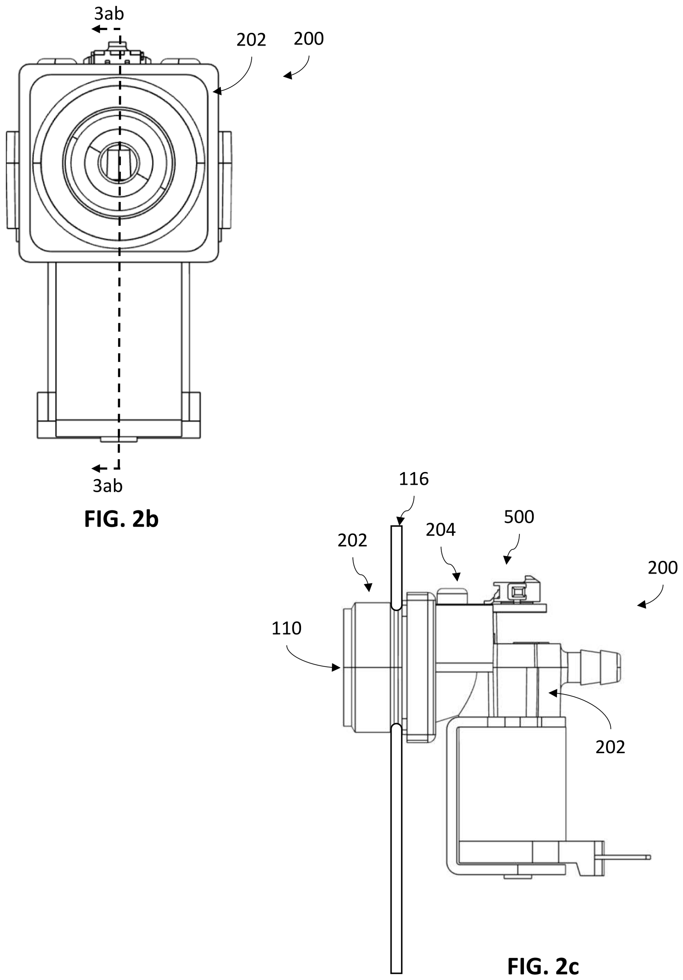

In the example of FIG. 1, the fluid line 114 extends through a valve and sensor assembly 200 of the welding-type power supply 106. The valve and sensor assembly 200 is shown in dashed lines to indicate that the valve and sensor assembly 200 is housed within the power supply housing 116. The valve and sensor assembly 200 is discussed further below with respect to FIGS. 2a-4.

The valve and sensor assembly 200 is shown as being (e.g., electrically) connected with control circuitry 118 of the welding-type power supply 106. The control circuitry 118 is shown in dashed lines to indicate that the control circuitry 118 is housed within the power supply housing 116. In some examples, the control circuitry 118 includes processing circuitry and/or memory circuitry.

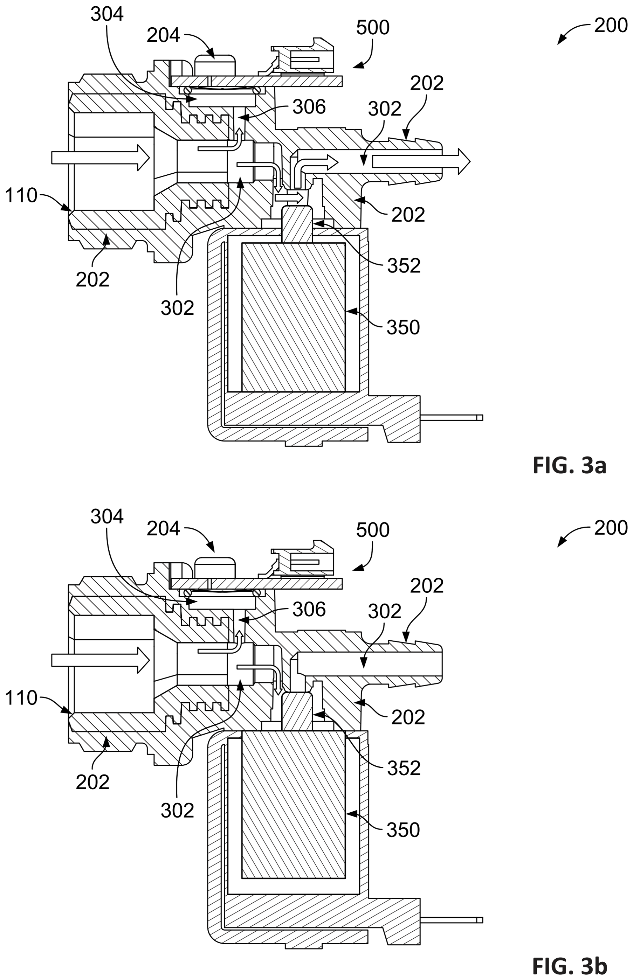

In some examples, the control circuitry 118 uses one or more control signals to control a (e.g., solenoid, proportional, etc.) valve 350 of the valve and sensor assembly 200 (see, e.g., FIGS. 3a-3b). In some examples, the control circuitry 118 controls the valve 350 to be open when a welding-type operation is occurring and/or about to occur. In some examples, the control circuitry controls the valve 350 to be closed when a welding-type operation is not occurring.

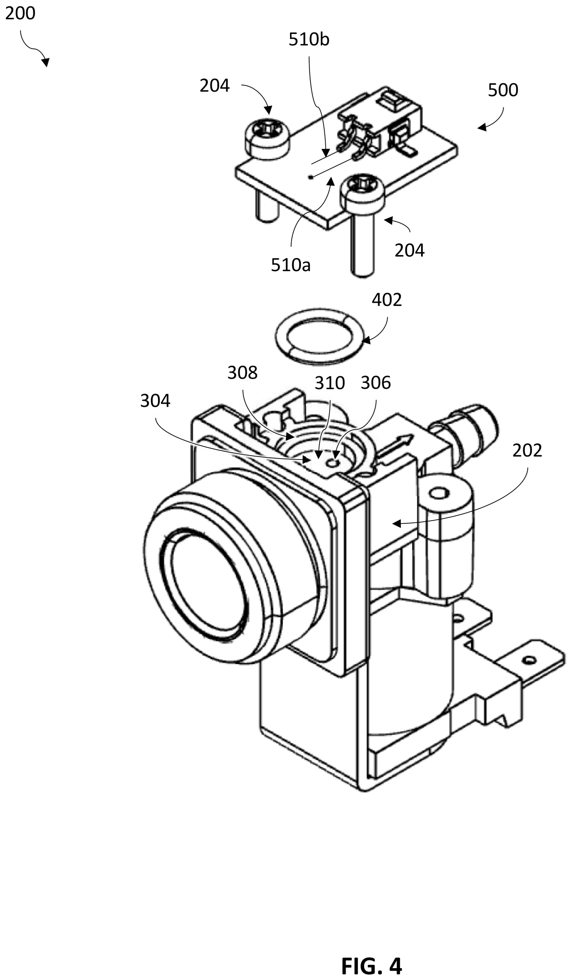

In some examples, the control circuitry 118 receives one or more sensor signals from a fluid sensor 500 (see, e.g., FIGS. 4-5c) of the valve and sensor assembly 200. In some examples, the one or more sensor signals indicate whether or not the fluid sensor 500 detects the presence of fluid at the fluid input connector 110 (and/or in the fluid line 114) of the welding-type power supply 106. In some examples, the fluid sensor 500 sends one or more sensor signals to the control circuitry 118 indicating whether the fluid sensor 500 detects the presence of fluid at the fluid input connector 110 (and/or in the fluid line 114) of the welding-type power supply 106.

In some examples, the control circuitry 118 determines whether there is fluid available for a welding-type operation based on the one or more sensor signals sent by the fluid sensor 500. In some examples, the control circuitry 118 provides an output via an operator interface 120 of the welding-type power supply 106 indicating whether there is fluid available for a welding-type operation, and/or disables the welding-type power supply 106 if there is no fluid available.

In some examples, the operator interface 120 of the welding-type power supply 106 includes one or more input devices and/or output devices. Examples of input devices include touch screens, keyboards, microphones, buttons, knobs, levers, switches, dials, slides, and/or other input devices. Examples of output devices include display screens, speakers, lights, haptic devices, and/or other output devices. In some examples, the operator interface 120 is in electrical communication with the control circuitry 118 of the welding-type power supply 106.

In the example of FIG. 1, the control circuitry 118 is shown (e.g., electrically) connected with power conversion circuitry 122 of the welding-type power supply 106. The power conversion circuitry 122 is shown in dashed lines to indicate that the power conversion circuitry 122 is housed within the power supply housing 116. In some examples, the power conversion circuitry 122 converts input power (e.g., from a generator, mains power, a battery, etc.) into welding-type output power.

In some examples, the power conversion circuitry 122 includes circuit elements (e.g., transformers, rectifiers, capacitors, inductors, diodes, transistors, switches, and so forth) capable of converting input power to welding-type output power. In some examples, the power conversion circuitry 122 includes one or more controllable circuit elements (e.g., switches, relays, transistors, etc.) configured to change states (e.g., fire, turn on/off, close/open, etc.) based on one or more control signals (e.g., received from the control circuitry 118). In some examples, the state(s) of the controllable circuit elements may impact the operation of the power conversion circuitry 122, and/or impact characteristics (e.g., current/voltage magnitude, frequency, waveform, etc.) of the welding-type output power provided by the power conversion circuitry 122. In some examples, the control circuitry 118 is configured to control operation of the power conversion circuitry 122 via one or more control signals that control operation of the controllable circuit elements.

In some examples, welding-type output power (e.g., produced via the power conversion circuitry 122) is output (e.g., along with fluid) from the output connector 112 of the welding-type power supply 106. In the example of FIG. 1, an output cable 126 is shown connecting the output connector 112 of the power supply 106 to a wire feeder 126.

In some examples, the wire feeder 126 includes one or more motorized rollers configured to feed welding wire from a wire spool to a welding-type tool 130. As shown, the wire feeder 126 is connected to the welding-type tool 130 via a feeder cable 128. In some examples, the wire feeder 126 feeds welding wire, fluid, and/or welding-type output power to the welding-type tool 130 via the feeder cable 128.

While depicted in FIG. 1 as a welding torch or gun configured for gas metal arc welding (GMAW), in some examples, the welding-type tool 130 may instead be a different welding-type tool 130. For example, the welding-type tool 130 may be an electrode holder (i.e., stinger) configured for shielded metal arc welding (SMAW), a torch and/or filler rod configured for gas tungsten arc welding (GTAW), a welding gun configured for flux-cored arc welding (FCAW), and/or a plasma cutter. Though shown separately in the example of FIG. 1, in some examples, the wire feeder 126 is instead incorporated into the welding-type power supply 106, or omitted entirely (e.g., for GTAW).

In some examples, the welding-type power supply 106 and/or wire feeder 126 output power, wire, and/or fluid to the welding-type tool 130 for a welding-type operation. In some examples, the welding-type tool 130 may send one or more tool signals to the wire feeder 126 and/or welding-type power supply 106 indicating that a welding-type operation is or is about to occur and/or be initiated. In some examples, to initiate a welding-type operation, an operator provides one or more inputs to the welding-type tool 130 (e.g., by squeezing a trigger, pressing a pedal, etc.).

In some examples, when a welding-type operation is or is about to occur and/or be initiated, the control circuitry 118 of the welding-type power supply 106 controls and/or opens the valve 350 of the valve and sensor assembly 200 (see, e.g., FIGS. 3a-3b). Once the valve 350 is opened, fluid can flow through the fluid line 114 of the power supply 106, through the output connector 112, through the output cable 124, through the wire feeder 126 and/or feeder cable 128, and to the welding-type tool 130for use during the welding-type operation.

However, if the operator has not first opened the tank valve 104 to allow fluid to flow to the welding-type power supply 106, no fluid will be supplied to the welding-type tool 130 for the welding-type operation. Lack of fluid supplied to the welding-type tool 130 for the welding-type operation can negatively impact the welding-type operation (e.g., resulting in poor quality welds).

In some examples, the fluid sensor 500 of the valve and sensor assembly 200 is used to detect whether there is fluid flowing from the fluid tank 102 to the fluid input connector 110 of the welding-type power supply 106 (e.g., via the fluid conduit 108). In some examples, if there is no fluid flowing to the welding-type power supply 106, the control circuitry 118 of the welding-type power supply outputs a warning via the operator interface 120, or disables the welding-type power supply 106 entirely, in an attempt to prevent the operator from performing a welding-type operation with no fluid (which can have negative consequences). It can thus be important for the fluid sensor 500 of the valve and sensor assembly 200 to accurately detect and/or communicate whether fluid is flowing to the fluid input connector 110 of the welding-type power supply 106.

FIGS. 2a-4 show examples of the valve and sensor assembly 200. As shown, the example valve and sensor assembly 200 includes a valve 350 and a fluid sensor 500 held together in an assembly casing 202.

In the examples of FIGS. 2a-4, the assembly casing 202 is shown as connecting the valve and sensor assembly 200 to the fluid input connector 110 (e.g., of the welding-type power supply 106 shown in FIG. 1. In some examples, the connection between the fluid input connector 110 and the valve and sensor assembly 200 may result in part of the assembly casing 202 (and/or fluid input connector 110) extending outside the power supply housing 116 of the welding-type power supply 106 (such as shown, for example, in FIG. 2c).

As shown in FIGS. 3a-3b, the assembly casing 202 defines a fluid path 302 extending through the valve and sensor assembly 200. As shown, the end of the fluid path 302 adjacent the fluid input connector 110 serves as an entrance into the valve and sensor assembly 200. The opposite end of the fluid path 302 is an exit from the valve and sensor assembly 200. In some examples, the exit of the fluid path 302 is configured for connection to the fluid line 114 (e.g., of the welding-type power supply 106 shown in FIG. 1). In some examples, the fluid path 302 may be considered part of the fluid line 114 (e.g., of the welding-type power supply 106 shown in FIG. 1).

In the examples of FIGS. 3a-3b, the fluid path 302 of the valve and sensor assembly 200 extends past the valve 350 of the valve and sensor assembly 200. In some examples, the valve 350 is movable between a closed position and an open position.

FIG. 3b shows an example of a closed position of the valve 350. As shown, when closed, a valve stem 352 of the valve 350 protrudes into and/or obstructs the fluid path 302 of the valve and sensor assembly 200. When the fluid path 302 is obstructed by the valve stem 352, fluid entering through the fluid path 302 is prevented from reaching the exit of the fluid path 302 (and/or continuing through the fluid line 114 to the welding-type tool 130).

FIG. 3a shows an example of an open position of the valve 350. As shown, when open, the valve stem 352 no longer protrudes into and/or obstructs the fluid path 302 of the valve and sensor assembly 200. When the fluid path 302 is not obstructed by the valve stem 352, fluid entering through the fluid path 302 is allowed to flow to the exit of the fluid path 302 (and/or continue flowing through the fluid line 114 to the welding-type tool 130).

Regardless of whether the valve 350 is controlled to be open or closed, the fluid sensor 500 of the valve and sensor assembly 200 is configured to detect whether fluid is present at the entrance of the fluid path 302 of the valve and sensor assembly 200. In the examples of FIGS. 2a-4, the fluid sensor 500 is attached to the assembly casing 202 via fasteners 204 (e.g., screws, bolts, etc.). As shown, the fluid sensor 500 is attached to the assembly casing 202 proximate the entrance of the fluid path 302 of the valve and sensor assembly 200.

In the example of FIGS. 3a-4, the fluid sensor 500 is shown attached to the assembly casing 202 adjacent to a fluid chamber 304 defined by the assembly casing 202. As shown, the fluid chamber 304 is positioned proximate to, offset from, and/or in fluid communication with, the entrance of the fluid path 302. The fluid chamber 304 is further shown fluidly connected with the fluid path 302 via a fluid passageway 306. In this configuration, fluid will flow into the fluid chamber 304 regardless of whether the fluid path 302 is open or closed by the valve 350, thereby allowing the fluid sensor 500 to detect whether fluid is present regardless of whether the fluid path 302 is open or closed by the valve 350.

In the example of FIG. 4, the fluid chamber 304 is shown as a generally cylindrical basin. One end of the fluid chamber 304 is shown as having an end wall 310. The fluid passageway 306 provides an entryway into the basin of the fluid chamber 304 through the end wall 310. The other end of the fluid chamber 304 is shown as having an opening 308 that is sealed by an O-ring 402. The fluid sensor 500 is attached to the assembly casing 202 adjacent the opening 308 of the fluid chamber 304 such that fluid entering the fluid chamber 304 will exert a fluid pressure against the fluid sensor 500.

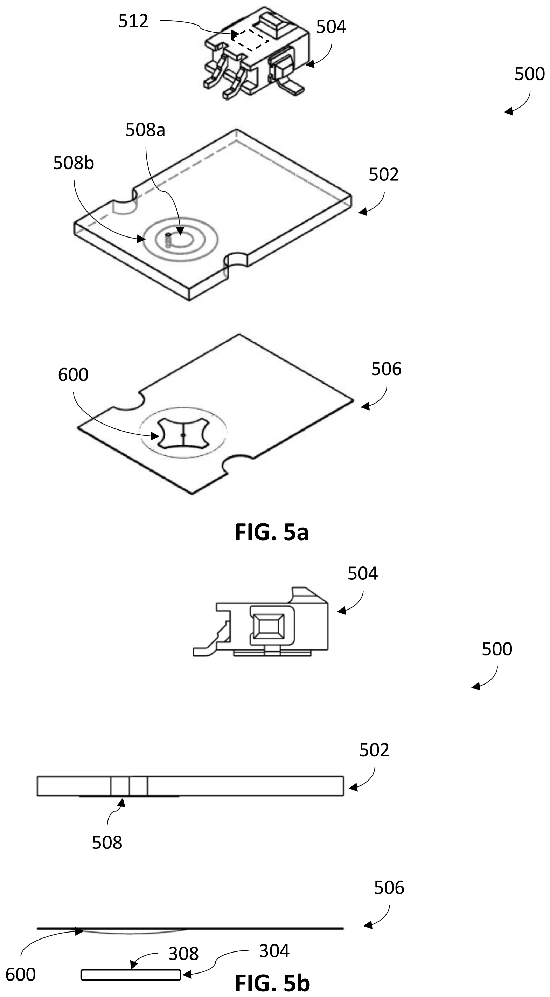

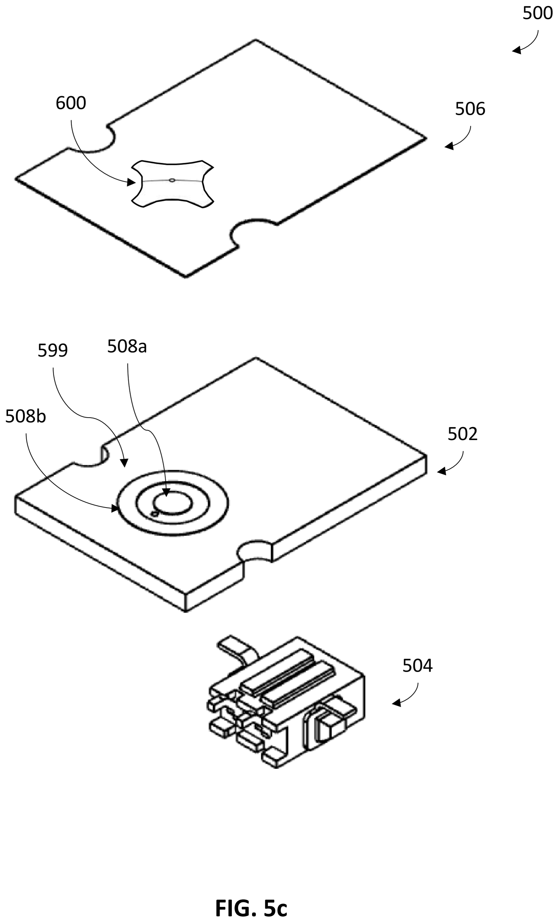

FIGS. 5a-5c show expanded and exploded views of the fluid sensor 500. FIG. 5a shows an exploded view of the fluid sensor 500 at one perspective view. FIG. 5c shows an exploded view of the fluid sensor 500 from a different (e.g., one hundred and eighty degree shifted) perspective view. FIG. 5b shows an exploded view of the fluid sensor 500 from a side view.

As shown, the fluid sensor 500 includes a circuit board 502, a sensor interface 504, and a bonding sheet 506. The circuit board 502 is shown as generally flat and rectangular, with semicircular cutouts to accommodate the fasteners 204. The sensor interface 504 attaches to one face of the circuit board 502 while the bonding sheet 506 bonds to an opposite face of the circuit board 502. In some examples, the side of the bonding sheet 506 facing the circuit board 502 is coated with an adhesive that will bond the bonding sheet 506 to the circuit board 502.

In the examples of FIGS. 5a-5c, a contact switch 600 is disposed on and/or integrated into the bonding sheet 506. In some examples, the contact switch 600 is a formed from an electrically conductive material, such as, for example, a metallic material. In some examples, the rest of the bonding sheet 506 is made from an electrically insulating material, such as plastic, for example. In some examples, there is no adhesive present at and/or on the contact switch 600 itself.

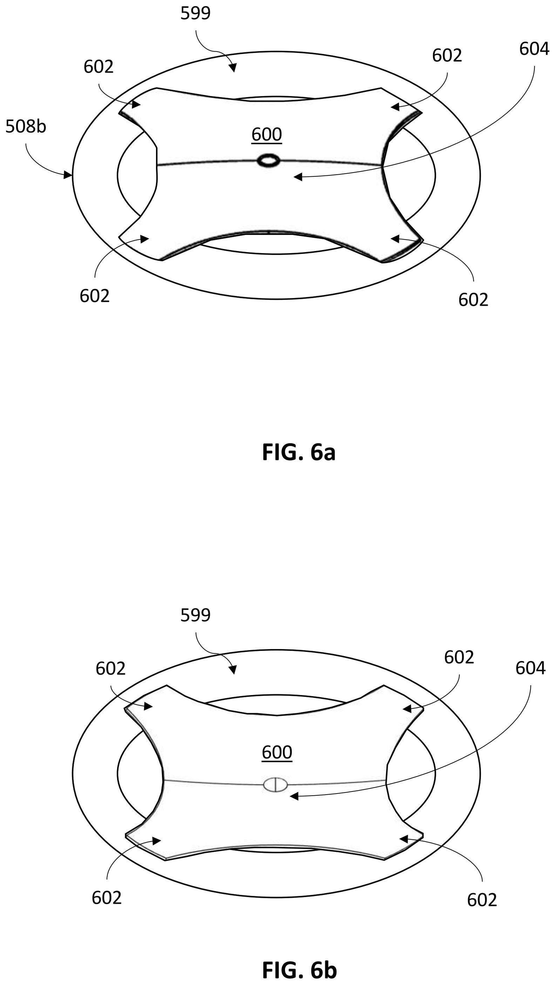

FIGS. 6a-6b show enlarged depictions of the contact switch 600. In the examples of FIGS. 6a-6b the contact switch 600 is approximately cross and/or X shaped. As shown, the contact switch 600 includes four legs 602, with each leg 602 spaced approximately equidistantly apart from each other adjacent leg 602. In the example of FIG. 6a, each leg 602 is shown as being curved, arcing up to connect to a dome 604 at an approximate center of the contact switch 600. The curvature of the legs 602 and/or dome 604 results in the contact switch 600 normally curving out of alignment with the flat planar surface of the bonding sheet 506, such as shown, for example, in FIG. 5b.

As shown in FIGS. 5a-5c, the contact switch 600 of the bonding sheet 506 is aligned with two switch contact surfaces 508 of the circuit board 502. The circuit board 502 is shown as at least partially transparent in the example of FIG. 5a to show the alignment between the contact switch 600 and the switch contact surfaces 508 on the non-visible face of the circuit board 502.

In the examples of FIGS. 5a and 5c, the switch contact surfaces 508 of the circuit board 502 include an inner switch contact surface 508a and an outer switch contact surface 508b. The inner switch contact surface 508a is shown as a solid circle, while the outer switch contact surface 508b is shown as a hollow circle and/or ring that encircles the inner switch contact surface 508a. An intervening hollow circle and/or ring of circuit board 502 is shown separating the inner switch contact surface 508a and outer switch contact surface 508b.

In some examples, the switch contact surfaces 508 are formed of an electrically conductive material, such as a metallic material, for example. In some examples, the portion of the circuit board 502 separating the switch contact surfaces 508 is formed of an insulating material, such as fiberglass for example.

As shown, the switch contact surfaces 508 are positioned on a face of the circuit board 502 to which the bonding sheet 506 is adhesively bonded. In some examples, the contact switch 600 is positioned on the face of the bonding sheet 506 that bonds with the circuit board 502. In some examples, the contact switch 600 spans both faces of the bonding sheet 506.

FIGS. 6a-6b show how the legs 602 of the contact switch 600 contact and/or electrically connect with the outer switch contact surface 508b when the bonding sheet 506 adhesively bonds to the circuit board 502. As shown, when the bonding sheet 506 is bonded to the circuit board 502 and the contact switch 600 is at rest, with no outside force acting against it, the legs 602 make contact with the outer switch contact surface 508b, and the central dome 604 is spaced away from the inner switch contact surface 508a (e.g., due to the arcuate shape of the legs 602). Thus, no electrical contact is made between the central dome 604 of the contact switch 600 and the inner switch contact surface 508a of the circuit board 502 at steady state, when the contact switch 600 is at rest, with no outside force (e.g., fluid pressure) acting against it.

As illustrated in FIG. 5b, the switch contact surfaces 508 and the contact switch 600 are aligned with the opening 308 of the fluid chamber 304. When the bonding sheet 506 is adhesively bonded to the circuit board 502, and the circuit board 502 is attached to the assembly casing (e.g., via fasteners 204), the switch contact surfaces 508 and the contact switch 600 are positioned in and/or adjacent the opening 308 of the fluid chamber 304. Due to the curvature of the legs 602 of the contact switch 600, the central dome 604 of the contact switch 600 also slightly protrudes from the bonding sheet 506 and/or circuit board 502 into the fluid chamber 304.

In some examples, when fluid fills the fluid chamber 304, the fluid pressure within the fluid chamber 304 increases (and air/atmosphere is pushed out of the fluid chamber 304 through vent holes in the contact switch 600 and circuit board 502). When the fluid pressure within the fluid chamber 304 exceeds a pressure threshold, the fluid pressure forces the central dome 604 of the contact switch 600 to deform, bend inwards, and/or flatten. In some examples, when deformed, bent, and/or flattened, the central dome 604 (and/or the entire contact switch 600) is moved into the same plane as the rest of the bonding sheet 506. In some examples, the deformation of the central dome 604 and/or contact switch 600 causes the central dome 604 to make electrical contact with the inner switch contact surface 508a of the circuit board 502. FIG. 6b shows an example of how the contact switch 600 (and/or central dome 604 of the contact switch 600) might deform, change shape, flatten out, and/or bend inwards in response to experiencing a fluid pressure greater than a pressure threshold.

In some examples, the contact switch 600 completes an electrical circuit when the central dome 604 of the contact switch 600 makes electrical contact with the inner switch contact surface 508a of the circuit board 502, and one or more of the legs 602 of the contact switch 600 make electrical contact with the outer switch contact surface 508b of the circuit board 502. As shown in FIG. 4, circuit board traces 510 extend across and/or through the circuit board 502 to connect the switch contact surfaces 508 to the sensor interface 504. In some examples, the switch contact surfaces 508 and circuit board traces 510 form a sensing circuit that is completed when the central dome 604 of the contact switch 600 makes electrical contact with the inner switch contact surface 508a of the circuit board 502, and one or more of the legs 602 of the contact switch 600 make electrical contact with the outer switch contact surface 508b of the circuit board 502. In some examples, the sensor interface 504 is configured to generate an output signal based on whether or not the sensing circuit is completed.

In the example of FIG. 5a, the sensor interface 504 is shown as including interface circuitry 512. In some examples, the interface circuitry 512 comprises analog and/or digital circuitry (e.g., one or more AND/OR gates, switches, transistors, etc.) configured to generate one or more output signals representative of and/or indicating whether or not the sensing circuit is completed. In some examples, the interface circuitry 512 is considered part of the sensing circuit.

In some examples, the sensor interface 504 connects to the control circuitry 118 of the welding-type power supply 106 (e.g., via one or more electrical cables). In some examples, the interface circuitry 512 includes one or more electrical contacts configured for electrical connection with one or more electrical cables that connect with the control circuitry 118 of the welding-type power supply 106.

In some examples, the control circuitry 118 provides electrical power to the sensor interface 504 (e.g., to power the sensing circuit). In some examples, the sensor interface 504 sends one or more output signals to the control circuitry 118 representative of and/or indicating whether or not the sensing circuit is completed, and/or whether fluid has been detected by the fluid sensor 500.

In some examples, proper operation of the fluid sensor 500 depends upon the ability of the contact switch 600 to deform when experiencing fluid pressure greater than a pressure threshold (such as shown, for example, in FIG. 6b). In some examples, proper operation of the fluid sensor 500 also depends upon the ability of the contact switch 600 to undeform and/or revert to its normal shape when fluid pressure greater than a pressure threshold is no longer present (such as shown, for example, in FIG. 6a). In some examples, the contact switch 600 is formed of a somewhat elastic material so that the contact switch 600 can both deform and undeform properly.

However, in some examples where the fluid pressure reaches higher levels (e.g., a threshold amount above the threshold pressure) for a long (e.g., threshold amount of) time, the contact switch 600 (and/or central dome 604) can experience issues reverting back to its normal shape. This can be caused by adhesive on the bonding sheet 506 proximate and/or between the legs 602 of the contact switch 600 sticking and/or bonding proximate the outer switch contact surface 508b. This additional bonding of the bonding sheet 506 so close to the central dome 604 can sometimes produce enough bonding force to override the elastic force of the contact switch 600, and thereby prevent the (e.g., central dome 604 of the) contact switch 600 from reverting back to its normal shape after the fluid pressure has been removed and/or reduced below the pressure threshold.

While some higher pressure (e.g., plasma) welding-type systems 100 use fluid sensors 500 with fully circular/domed contact switches (instead of X shaped contact switches 600 with legs 602), these fully circular/domed contact switches have a higher pressure threshold. Thus, more fluid pressure is required before the fully circular/domed contact switches experience deformation.

In lower pressure (e.g., GMAW, GTAW, etc.) welding-type systems 100, such high pressures (and/or pressure thresholds) are rarely reached. This can result in a failure of the fully circular/domed contact switches to deform when fluid is present, which can result in a failure of the fluid sensor 500 to correctly indicate when fluid is present. In order to accommodate the lower pressure (e.g., GMAW, GTAW, etc.) welding-type systems 100, the fully circular/domed contact switches were modified to have less material, and a lower pressure threshold for deformation, resulting in the X shaped contact switches 600 with legs 602 shown in FIGS. 6a-6b.

However, the X shaped contact switches 600 can sometimes experience issues reverting back to their original shapes due to adhesive bonding of the bonding sheet 506 between the legs 602 of the contact switches 600 (and/or proximate thereto), as discussed above. To counteract and/or guard against this unwanted and/or undesirable adhesive bonding, this disclosure contemplates the use of a bond resisting substance 599.

FIGS. 5c-6b show the circuit board 502 and outer switch contact surface 508b treated with a bond resisting substance 599. In some examples, the bond resisting substance is a dry powder substance that resists and/or prevents the adhesive of the bonding sheet 506 from bonding to the outer switch contact surface 508b and/or circuit board 502, particularly between the legs 602 of the contact switch 600. In some examples, the bond resisting substance 599 is a lubricant or grease substance (e.g., a conductive grease) that resists and/or prevents the adhesive of the bonding sheet 506 from bonding to the outer switch contact surface 508b and/or circuit board 502, particularly between the legs 602 of the contact switch 600.

While shown as being applied to the circuit board 502 in the example of FIG. 5c, in some examples, the bond resisting substance 599 may additionally, or alternatively, be applied to the bonding sheet 506. In some examples, the bond resisting substance 599 is applied before and/or during assembly of the fluid sensor 500, and/or before bonding of the bonding sheet 506 to the circuit board 502.

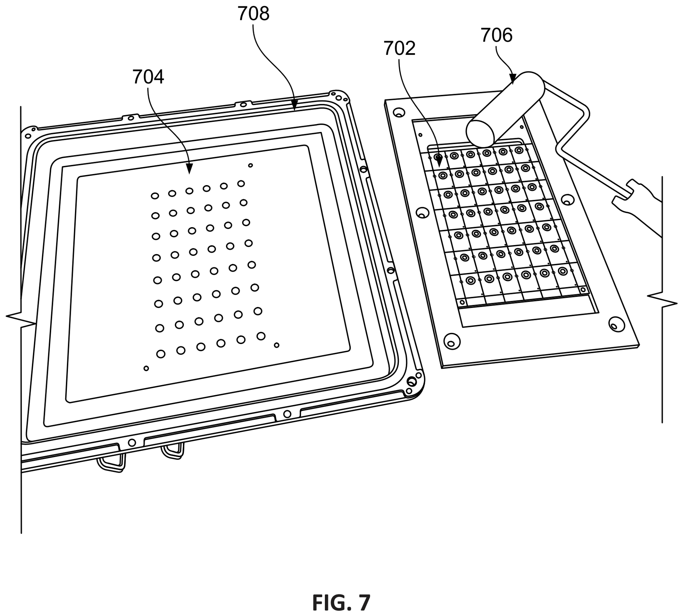

In some examples, the bond resisting substance 599 is applied to a panel 702 of several circuit boards 502 using a stencil 704 and/or a roller 706 while the panel 702 of circuit boards 502 is held by a fixture 708, such as showed in FIG. 7. Such tools are readily available and/or familiar to manufacturers, as they are sometimes also used to apply thermal paste to a heat sink before attachment to an electronic device (e.g., a microchip, processing unit, etc.). The availability and/or familiarity of such tools may make an application process using those tools particularly efficient, cost effective, and/or effective.

In some examples, the use of conductive grease as the bond resisting substance 599 may also be particularly efficient and/or effective, as it allows for inaccuracies to occur with little negative consequence. For example, if the bond resisting substance 599 is a powder and is mistakenly applied where a leg 602 of the contact switch 600 is intended to make electrical contact with the outer switch contact surface 508b, or where the central dome 604 of the contact switch 600 is intended to make electrical contact with the inner switch contact surface 508a, the powder may prevent an electrical connection between the contact switch 600 and switch contact surface 508 (e.g., due to electrically insulating properties of the powder). However, if the bond resisting substance is a conductive grease and the conductive grease is mistakenly applied where a leg 602 of the contact switch 600 is intended to make electrical contact with the outer switch contact surface 508b, or where the central dome 604 of the contact switch 600 is intended to make electrical contact with the inner switch contact surface 508a, the electrical connection between the contact switch 600 and switch contact surface 508 can still occur (e.g., due to the electrically conductive properties of the conductive grease).

In some examples, the bond resisting substance 599 may instead be a lack of a substance. For example, the bonding sheet 506 might be modified such that there is no adhesive between and/or proximate the legs 602 of the contact switch 600. With no adhesive in the area, there is no risk that prolonged and/or overly pronounced fluid pressure will cause unwanted bonding between the legs 602 of the contact switch 600, and/or prevent reversion of the contact switch 600 to a normal shape after deformation and/or withdrawal of fluid pressure over a pressure threshold. As another example, holes might be placed in the circuit board 502 between and/or proximate the legs 602 of the contact switch 600 to reduce the force of any unwanted bonding between the legs 602 of the contact switch 600. However, modification of the bonding sheet 506 and/or circuit board 502 to insert holes and/or remove adhesive may be less effective, more difficult, more costly, more time consuming, and/or more inefficient than using the bond resisting substance 599.

The present disclosure contemplates the use of a bond resisting substance 599 (e.g., a powder and/or grease substance) to resist over extensive and/or unwanted adhesive bonding in a fluid sensor 500. In some examples, the bond resisting substance 599 is applied between a bonding sheet 506 and a circuit board 502 of the fluid sensor 500 to resist and/or prevent unwanted and/or overly extensive adhesive bonding of the bonding sheet 506 to the circuit board 502. In some examples, resisting and/or preventing the unwanted and/or overly extensive adhesive bonding helps to ensure a contact switch 600 of the fluid sensor 500 is able to both deform and undeform properly, which ensures proper operation of the fluid sensor 500, and/or proper operation of the welding-type system 100 using the fluid sensor 500.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

As used herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

As utilized herein, the terms "e.g.," and "for example" set off lists of one or more non-limiting examples, instances, or illustrations.

As used herein, the terms "coupled," "coupled to," and "coupled with," each mean a structural and/or electrical connection, whether attached, affixed, connected, joined, fastened, linked, and/or otherwise secured. As used herein, the term "attach" means to affix, couple, connect, join, fasten, link, and/or otherwise secure. As used herein, the term "connect" means to attach, affix, couple, join, fasten, link, and/or otherwise secure.

As used herein the terms "circuits" and "circuitry" refer to physical electronic components (i.e., hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As utilized herein, circuitry is "operable" and/or "configured" to perform a function whenever the circuitry comprises the necessary hardware and/or code (if any is necessary) to perform the function, regardless of whether performance of the function is disabled or enabled (e.g., by a user-configurable setting, factory trim, etc.).

As used herein, a control circuit may include digital and/or analog circuitry, discrete and/or integrated circuitry, microprocessors, DSPs, etc., software, hardware and/or firmware, located on one or more boards, that form part or all of a controller, and/or are used to control a welding process, and/or a device such as a power source or wire feeder.

As used herein, the term "processor" means processing devices, apparatus, programs, circuits, components, systems, and subsystems, whether implemented in hardware, tangibly embodied software, or both, and whether or not it is programmable. The term "processor" as used herein includes, but is not limited to, one or more computing devices, hardwired circuits, signal-modifying devices and systems, devices and machines for controlling systems, central processing units, programmable devices and systems, field-programmable gate arrays, application-specific integrated circuits, systems on a chip, systems comprising discrete elements and/or circuits, state machines, virtual machines, data processors, processing facilities, and combinations of any of the foregoing. The processor may be, for example, any type of general purpose microprocessor or microcontroller, a digital signal processing (DSP) processor, an application-specific integrated circuit (ASIC), a graphic processing unit (GPU), a reduced instruction set computer (RISC) processor with an advanced RISC machine (ARM) core, etc. The processor may be coupled to, and/or integrated with a memory device.

As used, herein, the term "memory" and/or "memory device" means computer hardware or circuitry to store information for use by a processor and/or other digital device. The memory and/or memory device can be any suitable type of computer memory or any other type of electronic storage medium, such as, for example, read-only memory (ROM), random access memory (RAM), cache memory, compact disc read-only memory (CDROM), electro-optical memory, magneto-optical memory, programmable read-only memory (PROM), erasable programmable read-only memory (EPROM), electrically-erasable programmable read-only memory (EEPROM), a computer-readable medium, or the like. Memory can include, for example, a non-transitory memory, a non-transitory processor readable medium, a non-transitory computer readable medium, non-volatile memory, dynamic RAM (DRAM), volatile memory, ferroelectric RAM (FRAM), first-in-first-out (FIFO) memory, last-in-first-out (LIFO) memory, stack memory, non-volatile RAM (NVRAM), static RAM (SRAM), a cache, a buffer, a semiconductor memory, a magnetic memory, an optical memory, a flash memory, a flash card, a compact flash card, memory cards, secure digital memory cards, a microcard, a minicard, an expansion card, a smart card, a memory stick, a multimedia card, a picture card, flash storage, a subscriber identity module (SIM) card, a hard drive (HDD), a solid state drive (SSD), etc. The memory can be configured to store code, instructions, applications, software, firmware and/or data, and may be external, internal, or both with respect to the processor.

The term "power" is used throughout this specification for convenience, but also includes related measures such as energy, current, voltage, and enthalpy. For example, controlling "power" may involve controlling voltage, current, energy, and/or enthalpy, and/or controlling based on "power" may involve controlling based on voltage, current, energy, and/or enthalpy.

As used herein, welding-type refers to welding (including laser welding and/or hot wire welding), cladding (including laser cladding), brazing, plasma cutting, induction heating, carbon arc cutting or gouging, hot wire preheating, and/or resistive preheating.

As used herein, a welding-type tool refers to a tool suitable for and/or capable of welding (including laser welding and/or hot wire welding), cladding (including laser cladding), brazing, plasma cutting, induction heating, carbon arc cutting or gouging, hot wire preheating, and/or resistive preheating.

As used herein, welding-type power refers to power suitable for welding (including laser welding and/or hot wire welding), cladding (including laser cladding), brazing, plasma cutting, induction heating, carbon arc cutting or gouging, hot wire preheating, and/or resistive preheating.

As used herein, a welding-type power supply and/or welding-type power source refers to a device capable of, when input power is applied thereto, supplying output power suitable for welding (including laser welding and/or hot wire welding), cladding (including laser cladding), brazing, plasma cutting, induction heating, carbon arc cutting or gouging, hot wire preheating, and/or resistive preheating; including but not limited to transformer-rectifiers, inverters, converters, resonant power supplies, quasi-resonant power supplies, switch-mode power supplies, etc., as well as control circuitry and other ancillary circuitry associated therewith.

As used herein, disable may mean deactivate, incapacitate, and/or make inoperative. As used herein, enable may mean activate and/or make operational.

Disabling of circuitry, actuators, and/or other hardware may be done via hardware, software (including firmware), or a combination of hardware and software, and may include physical disconnection, de-energization, and/or a software control that restricts commands from being implemented to activate the circuitry, actuators, and/or other hardware. Similarly, enabling of circuitry, actuators, and/or other hardware may be done via hardware, software (including firmware), or a combination of hardware and software, using the same mechanisms used for disabling.
Certain embodiments of the invention are described in the following clauses:
Clause 1 A fluid sensor, comprising:
   a fluid chamber having a fluid inlet through which fluid can enter the fluid chamber, the fluid chamber further having a chamber opening;
   a circuit board positioned adjacent the fluid chamber, the circuit board comprising a switch contact surface positioned in or adjacent the chamber opening of the fluid chamber;
   a bonding sheet connected to the circuit board via an adhesive bond;
   a contact switch disposed on the bonding sheet, the contact switch being brought into electrical contact with the switch contact surface of the circuit board by the adhesive bond between the circuit board and the bonding sheet, the contact switch being positioned in or adjacent the chamber opening of the fluid chamber, the contact switch being configured to deform in response to a fluid pressure within the fluid chamber exceeding a pressure threshold; and
   a bond resisting substance positioned between the circuit board and the bonding sheet proximate the switch contact surface, the bond resisting substance resisting the adhesive bond between the circuit board and the bonding sheet proximate the switch contact surface, thereby stopping the adhesive bond between the circuit board and the bonding sheet from preventing reversion of the contact switch to an undeformed state after the fluid pressure within the fluid chamber no longer exceeds the pressure threshold.
Clause 2 The fluid sensor of clause 1, wherein the bond resisting substance comprises a powder or a grease.
Clause 3 The fluid sensor of clause 1, wherein the switch contact surface comprises a first switch contact surface, the circuit board further comprising a second switch contact surface that is electrically insulated from the first switch contact surface by an insulating portion of the circuit board.
Clause 4 The fluid sensor of clause 3 3, wherein the first switch contact surface encircles the second switch contact surface.
Clause 5 The fluid sensor of clause 3, wherein the contact switch is configured to make electrical contact with the second switch contact surface, and electrically connect the first and second switch contact surfaces, when the contact switch deforms in response to the fluid pressure within the fluid chamber exceeding the pressure threshold.
Clause 6 The fluid sensor of clause 4, wherein the circuit board further comprises circuit board circuitry configured to generate a fluid detection signal when the first and second switch contact surfaces are electrically connected, and generate a fluid non-detection signal when the first and second switch contact surfaces are not electrically connected.
Clause 7 The fluid sensor of clause 1, wherein the contact switch is comprised of an electrically conductive material.
Clause 8 The fluid sensor of clause 1, wherein the contact switch comprises a plurality of legs extending from a central dome, the plurality of legs being in electrical contact with the switch contact surface of the circuit board.
Clause 9 The fluid sensor of clause 8, wherein the central dome is configured to deform in response to the fluid pressure within the fluid chamber exceeding the pressure threshold.
Clause 10 The fluid sensor of clause 8, wherein the plurality of legs comprises a first leg and a second leg, the bond resisting substance being applied to the switch contact surface between the first leg and the second leg, the bond resisting substance resisting the adhesive bond at the switch contact surface between the first leg and the second leg.
Clause 11 A method of manufacturing a fluid sensor, comprising:
   adhesively bonding a circuit board to a bonding sheet, the circuit board comprising a switch contact surface, and the bonding sheet comprising a contact switch that is brought into electrical contact with the switch contact surface of the circuit board by adhesively bonding the circuit board to the bonding sheet, the contact switch being configured to deform in response to a pressure exerted against the contact switch exceeding a pressure threshold;
   applying a bond resisting substance between the circuit board and the bonding sheet prior to adhesively bonding the circuit board to the bonding sheet, the bond resisting substance resisting an adhesive bond between the circuit board and the bonding sheet proximate the switch contact surface, thereby stopping the adhesive bond between the circuit board and the bonding sheet from preventing reversion of the contact switch to an undeformed state after the pressure exerted against the contact switch no longer exceeds the pressure threshold; and
   connecting the circuit board to a fluid chamber such that the contact switch and switch contact surface are positioned in or adjacent a chamber opening of the fluid chamber, the fluid chamber having a fluid inlet through which fluid can enter the fluid chamber and exert the pressure against the contact switch.
Clause 12 The method of clause 11, wherein the bond resisting substance comprises a powder or a grease.
Clause 13 The method of clause 11, wherein the switch contact surface comprises a first switch contact surface, the circuit board further comprising a second switch contact surface that is electrically insulated from the first switch contact surface by an insulating portion of the circuit board.
Clause 14 The method of clause 13, wherein the first switch contact surface encircles the second switch contact surface.
Clause 15 The method of clause 13, wherein the contact switch is configured to make electrical contact with the second switch contact surface, and electrically connect the first and second switch contact surfaces, when the contact switch deforms in response to the fluid pressure within the fluid chamber exceeding the pressure threshold.
Clause 16 The method of clause 14, wherein the circuit board further comprises circuit board circuitry configured to generate a fluid detection signal when the first and second switch contact surfaces are electrically connected, and generate a fluid non-detection signal when the first and second switch contact surfaces are not electrically connected.
Clause 17 The method of clause 11, wherein the contact switch is comprised of an electrically conductive material.
Clause 18 The method of clause 11, wherein the contact switch comprises a plurality of legs extending from a central dome, the plurality of legs being in electrical contact with the switch contact surface of the circuit board.
Clause 19 The method of clause 18, wherein the central dome is configured to deform in response to the pressure within the fluid chamber exceeding the pressure threshold.
Clause 20 The method of clause 18, wherein the plurality of legs comprises a first leg and a second leg, the bond resisting substance being applied to the switch contact surface between the first leg and the second leg, the bond resisting substance resisting the adhesive bond at the switch contact surface between the first leg and the second leg.

## Claims

1. A fluid sensor, comprising:
a fluid chamber having a fluid inlet through which fluid can enter the fluid chamber, the fluid chamber further having a chamber opening;
a circuit board positioned adjacent the fluid chamber, the circuit board comprising a switch contact surface positioned in or adjacent the chamber opening of the fluid chamber;
a bonding sheet connected to the circuit board via an adhesive bond;
a contact switch disposed on the bonding sheet, the contact switch being brought into electrical contact with the switch contact surface of the circuit board by the adhesive bond between the circuit board and the bonding sheet, the contact switch being positioned in or adjacent the chamber opening of the fluid chamber, the contact switch being configured to deform in response to a fluid pressure within the fluid chamber exceeding a pressure threshold; and
a bond resisting substance positioned between the circuit board and the bonding sheet proximate the switch contact surface, the bond resisting substance resisting the adhesive bond between the circuit board and the bonding sheet proximate the switch contact surface, thereby stopping the adhesive bond between the circuit board and the bonding sheet from preventing reversion of the contact switch to an undeformed state after the fluid pressure within the fluid chamber no longer exceeds the pressure threshold.

2. The fluid sensor of claim 1, wherein the bond resisting substance comprises a powder or a grease.

3. The fluid sensor of claim 1, wherein the switch contact surface comprises a first switch contact surface, the circuit board further comprising a second switch contact surface that is electrically insulated from the first switch contact surface by an insulating portion of the circuit board.

4. The fluid sensor of claim 3, wherein the first switch contact surface encircles the second switch contact surface, or wherein the contact switch is configured to make electrical contact with the second switch contact surface, and electrically connect the first and second switch contact surfaces, when the contact switch deforms in response to the fluid pressure within the fluid chamber exceeding the pressure threshold.

5. The fluid sensor of claim 4, wherein the circuit board further comprises circuit board circuitry configured to generate a fluid detection signal when the first and second switch contact surfaces are electrically connected, and generate a fluid non-detection signal when the first and second switch contact surfaces are not electrically connected.

6. The fluid sensor of claim 1, wherein the contact switch is comprised of an electrically conductive material or
wherein the contact switch comprises a plurality of legs extending from a central dome, the plurality of legs being in electrical contact with the switch contact surface of the circuit board.

7. The fluid sensor of claim 6, wherein the central dome is configured to deform in response to the fluid pressure within the fluid chamber exceeding the pressure threshold, or
wherein the plurality of legs comprises a first leg and a second leg, the bond resisting substance being applied to the switch contact surface between the first leg and the second leg, the bond resisting substance resisting the adhesive bond at the switch contact surface between the first leg and the second leg.

8. A method of manufacturing a fluid sensor, comprising:
adhesively bonding a circuit board to a bonding sheet, the circuit board comprising a switch contact surface, and the bonding sheet comprising a contact switch that is brought into electrical contact with the switch contact surface of the circuit board by adhesively bonding the circuit board to the bonding sheet, the contact switch being configured to deform in response to a pressure exerted against the contact switch exceeding a pressure threshold;
applying a bond resisting substance between the circuit board and the bonding sheet prior to adhesively bonding the circuit board to the bonding sheet, the bond resisting substance resisting an adhesive bond between the circuit board and the bonding sheet proximate the switch contact surface, thereby stopping the adhesive bond between the circuit board and the bonding sheet from preventing reversion of the contact switch to an undeformed state after the pressure exerted against the contact switch no longer exceeds the pressure threshold; and
connecting the circuit board to a fluid chamber such that the contact switch and switch contact surface are positioned in or adjacent a chamber opening of the fluid chamber, the fluid chamber having a fluid inlet through which fluid can enter the fluid chamber and exert the pressure against the contact switch.

9. The method of claim 8, wherein the bond resisting substance comprises a powder or a grease.

10. The method of claim 8, wherein the switch contact surface comprises a first switch contact surface, the circuit board further comprising a second switch contact surface that is electrically insulated from the first switch contact surface by an insulating portion of the circuit board, and optionally wherein the first switch contact surface encircles the second switch contact surface.

11. The method of claim 10, wherein the contact switch is configured to make electrical contact with the second switch contact surface, and electrically connect the first and second switch contact surfaces, when the contact switch deforms in response to the fluid pressure within the fluid chamber exceeding the pressure threshold and optionally wherein the circuit board further comprises circuit board circuitry configured to generate a fluid detection signal when the first and second switch contact surfaces are electrically connected, and generate a fluid non-detection signal when the first and second switch contact surfaces are not electrically connected.

12. The method of claim 8, wherein the contact switch is comprised of an electrically conductive material.

13. The method of claim 8, wherein the contact switch comprises a plurality of legs extending from a central dome, the plurality of legs being in electrical contact with the switch contact surface of the circuit board.

14. The method of claim 13, wherein the central dome is configured to deform in response to the pressure within the fluid chamber exceeding the pressure threshold.

15. The method of claim 13, wherein the plurality of legs comprises a first leg and a second leg, the bond resisting substance being applied to the switch contact surface between the first leg and the second leg, the bond resisting substance resisting the adhesive bond at the switch contact surface between the first leg and the second leg.
